(19) Europäisches Patentamt / European Patent Office / Office européen des brevets

(11) **EP 1 704 602 B1**

(12) **EUROPÄISCHE PATENTSCHRIFT**

(45) Veröffentlichungstag und Bekanntmachung des Hinweises auf die Patenterteilung:
**19.12.2012 Patentblatt 2012/51**

(51) Int Cl.:
*H01L 41/187* (2006.01)   *H01L 41/083* (2006.01)
*C04B 35/491* (2006.01)   *C04B 35/493* (2006.01)

(21) Anmeldenummer: 05714869.4

(22) Anmeldetag: **14.01.2005**

(86) Internationale Anmeldenummer:
**PCT/DE2005/000045**

(87) Internationale Veröffentlichungsnummer:
**WO 2005/069396 (28.07.2005 Gazette 2005/30)**

(54) **KERAMIKMATERIAL**

CERAMIC MATERIAL

MATERIAU CERAMIQUE

(84) Benannte Vertragsstaaten:
**DE FR GB**

(30) Priorität: **15.01.2004 DE 102004002204**

(43) Veröffentlichungstag der Anmeldung:
**27.09.2006 Patentblatt 2006/39**

(73) Patentinhaber: **EPCOS AG**
**81669 München (DE)**

(72) Erfinder:
• **FELTZ, Adalbert**
**A-8530 Deutschlandsberg (AT)**
• **FLORIAN, Heinz**
**A-8524 Bad Gams (AT)**

• **SCHOSSMANN, Michael**
**A-8523 Frauental (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 0 344 978     WO-A-02/081404**

• **PATENT ABSTRACTS OF JAPAN Bd. 1996, Nr. 02, 29. Februar 1996 (1996-02-29) -& JP 07 277822 A (MATSUSHITA ELECTRIC IND CO LTD), 24. Oktober 1995 (1995-10-24)**

**Beschreibung**

Die Erfindung betrifft ein keramisches Material auf der Basis von Bleizirkonattitanat PZT. Es ist vorzugsweise für den Aufbau von piezokeramischen Vielschichtbauelementen geeignet und weist bei funktioneller Beanspruchung eine hervorragende thermische und zeitliche Stabilität der piezoelektrischen Eigenschaftsparameter auf.

Der Einsatz derartiger piezokeramischer Bauelemente als Sensoren oder Aktoren, insbesondere in der KFZ-Technik, ist an hohe Zuverlässigkeit und zeitliche Stabilität sowie eine hinreichende thermische Stabilität bei zugleich vergleichsweise hohen Auslenkungen gebunden, die sich bei Anlegen einer elektrischen Spannung ergeben. Letztere verlangen die Einstellung eines bestimmten Verhältnisses Zr zu Ti in der Perowskitstruktur $ABO_3$ von PZT, das der sogenannten morphotropen Phasengrenze MPB entspricht. Im Zusammensetzungsbereich der MPB nehmen die piezoelektrischen Eigenschaften besonders vorteilhafte Werte an. Darüber hinaus lassen sich die funktionellen Eigenschaften der Bleizirkonattitanatkeramik durch Zulegieren bestimmter Zusatzstoffe, die sich in der Perowskitstruktur fest lösen, sehr weitgehend auf den jeweiligen Anwendungsfall einstellen. Es wird im allgemeinen angestrebt, daß der für die thermische Stabilität der piezoelektrischen Eigenschaften maßgebende vergleichsweise hohe Wert der Curietemperatur von ca. 360°C durch derartige Modifizierungen nicht allzu sehr herabgemindert wird, was dadurch gelingt, daß man die Konzentration der Zusatzkomponente klein hält.

Aus der Druckschrift WO 97/40537 ist eine PZT-Keramik bekannt, bei der zur Verbesserung der Eigenschaften der Keramik eine Dotierung am A-Platz der Perowskitstruktur vorgesehen ist. Dabei wird zur A-Platz-Dotierung ein seltenes Erdmetall ausgewählt, vorzugsweise Lanthan oder Neodym.

Aus der Druckschrift C. Schuh et al., Proc. Electroceramics V, Aveiro 1996 Vol. 1, 201 ist ferner eine Zusammensetzung $Pb_{0,97}Nd_{0,02}[(zr_{0,3}Ti_{0,4}(Ni_{1/3}Nb_{2/3})_{0,3}]O_3]$ bekannt.

In der Druckschrift DE 198 40 488 A1 ist ferner der Einbau der Verbindung $Sr(K_{0,25}Nb_{0,75})O_3$ in das Perowskitgitter von PZT beschrieben.

Es ist Aufgabe der vorliegenden Erfindung, ein Keramikmaterial anzugeben, das gut für die Anwendung in Piezoaktoren geeignet ist.

Ferner ist es Aufgabe der Erfindung, ein Verfahren zur Herstellung des keramischen Materials anzugeben.

In einer Ausführungsform des Keramikmaterials weist diese die Summenformel $A'_{1-b-c}B'_bC'_c$ auf, wobei gilt: $0 \leq b \leq 0,5$ und $0 < c \leq 0,01$ und wobei

- A' für die Zusammensetzung $Pb(Zr_aTi_{1-a})O_3$ steht und wobei gilt $0,5 \leq a \leq 0,6$, und A' als Wirtsgitter für B' und C' dient,
- B' für eine Zusatzkomponente vom Perowskit - Gittertyp steht und ausgewählt ist aus einer der folgenden Komponenten:

    -- $KNbo_3$
    -- $Pb(M^{II}_{1/3}M^V_{2/3})O_3$ wobei $M^{II}$ für Co, Ni, Mn oder Cu und wobei $M^V$ für Nb, Ta oder Sb steht,
    -- $Pb(M^{II}_{1/2}M^{VI}_{1/2})O_3$ wobei $M^{II}$ für Zn, Co, Ni, Mn oder Cu und wobei $M^{VI}$ für W steht,
    -- $Pb(M^{III}_{1/2}M^V_{1/2})O_3$ wobei $M^{III}$ für Fe, Mn, Cr oder Ga und wobei $M^V$ für Nb, Ta oder Sb steht,
    -- $Pb(M^{III}_{2/3}M^{VI}_{1/3})O_3$ wobei $M^{III}$ für Fe, Mn, Cr oder Ga und wobei $M^{VI}$ für W steht,
    -- $Pb(Li^I_{1/4}M^V_{3/4})O_3$ wobei $M^V$ für Nb, Ta oder Sb steht,

- C' für ein Keramikmaterial vom Kryolith - Gittertyp steht, welches die allgemeine Formel $A_4(B_{2-2x/3}Nb_{2+2x/3})O_{11+x}V_{1-x}$ aufweist, und A für Strontium und Barium, B für Strontium, Calcium und Magnesium und V für eine Sauerstoffleerstelle mit Phasenbreite steht, und für den Parameter x gilt: $0 \leq x \leq 1$, wobei das Keramikmaterial $A'_{1-b-c}B'_bC'_c$ zusätzlich noch einen PbO-Überschuß von bis zu 3 mol-% enthalten kann.

Eine vorteilhafte Ausführungsform des Keramikmaterials basiert auf einer partiellen Substitution von $Pb^{II}$ und $Zr^{IV}/Ti^{IV}$ in der $Pb(Zr,Ti)O_3$-Keramik durch Ionen mit vergleichbaren Ionenradien, z. B. durch $A^{II}$-Kationen ($A^{II}$: Ba, Sr, Ca) auf den A-Plätzen und $B^{IV}$-Kationen ($B^{IV}$: Sn) auf den B-Plätzen der Perowskitstruktur. Im Rahmen einer solchen Mischkristallbildung ist darüber hinaus eine große Mannigfaltigkeit von Abwandlungen durch aliovalente Substitution möglich. Diese kann in einer paarweisen Substitution mit Valenzkompensation zwischen den A- und B-Plätzen der Perowskitstruktur bestehen, beispielsweise von $A^I$-Kationen ($A^I$: K, Ag) und $B^V$-Kationen ($B^V$: Nb, Ta, Sb) und deren Kombinationen, oder es kommen $A^{III}$-Kationen ($A^{III}$: $La^{III}$, $SE^{III}$, $Bi^{III}$) und $B^{III}$-Kationen ($B^{III}$: Al, Co, Mn) und deren Kombinationen in Betracht. Es sind auch Mischkristalle der aufgeführten drei Versionen realisierbar.

Neben der paarweise gekoppelten Substitution mit Valenzkompensation, bei der ein hoher Substitutionsgrad erreicht werden kann, besteht bei Einhaltung enger Konzentrationsgrenzen der Zusatzkomponente die Möglichkeit einer Substitution ohne Valenzkompensation. Im diesem Fall bleiben Gitterplätze temporär während des Sinterns oder auch bleibend unbesetzt. Sinterverdichtung und Gefügeausbildung werden dadurch gefördert, und es ergeben sich bei Einstellung des Zr/Ti-Verhältnisses auf die MPB besonders vorteilhafte piezoelektrische und piezomechanische Funktionseigenschaften.

Sogenannte weiche Piezokeramiken mit vergleichsweise flacherem Verlauf der ferroelektrischen Hysteresekurve im Polarisations-Feldstärke-Diagramm sind durch den Einbau höherwertiger Kationen auf den A-Plätzen, also von $A^{III}$ anstelle von $Pb^{II}$, oder den Einbau höherwertiger Kationen $B^V$ anstelle von $Zr^{IV}/Ti^{IV}$ auf den B-Plätzen realisierbar, ohne daß Valenzkompensation wie bei der paarweise gekoppelten Substitution vorliegt. Auf Grund der mit einer solchen Dotierung verbundenen Ausbildung von Leerstellen auf den A-Plätzen ist das Kornwachstum im Sinterprozess kinetisch begünstigt und ebenso die Domänenwandbewegung bei Einwirkung eines elektrischen Feldes, was zu hohen Werten der Dielektrizitätskonstante $\varepsilon$ und hohen Auslenkungsbeträgen bei vergleichsweise moderater Feldstärke von ca. 2 kV/mm führt, allerdings auch mit einer Verminderung der Elastizität und Erhöhung der dielektrischen Verluste verknüpft ist.

Piezokeramische Systeme dieses Typs entsprechen beispielsweise der Formel $Pb_{1-3x/2}La_xV_{Pb,x/2}(Zr_{0,53}Ti_{0,47})O_3$ ($V_{Pb}$ = Leerstelle auf $Pb^{II}$-Platz) (0,005 < x < 0,02), wobei anstelle von $La^{III}$ auch andere Kationen der Seltenen Erdelemente $SE^{III}$ in Frage kommen, z. B. $Nd^{III}$ in $Pb_{1-3x/2}Nd_xV_{Pb,x/2}(Zr_{0,53}Ti_{0,47})O_3$ mit x = 0,02. Es kann gezeigt werden, daß eine solche Keramik im Vielschichtbauelement eines Aktors mit Ag/Pd-Innenelektroden nach dem Sintern an Luft infolge Einwanderung von $Ag^I$-Ionen in die Leerstellen die Zusammensetzung $Pb_{0,96}Nd_{0,02}Ag_{0,02}(Zr_{0,54}Ti_{0,46})O_3$ annimmt. Weitere Substitutionen durch Kationen der Seltenen Erden $Pb_{0,97}A^{III}_{0,02}V_{Pb,0,01}(Zr_{0,535}Ti_{0,465})O_3$ mit A = La, Nd, Eu, Gd, Er, und auch Bi sind gleichfalls möglich. Die Variante einer Substitution von B-Plätzen ohne Valenzkompensation liegt im Fall Niob dotierter Piezokeramiken als $Pb_{1-x/2}V_{Pb,x/2}(Zr_{1-p}Ti_p)_{1-x}Nb_xO_3$ vor. Auch die komplexe Zusammensetzung einer vergleichsweise harten Piezokeramik $Pb_{0,99}V_{0,01}([(Zr_xSn_{1-x})_{1-y}Ti_y]_{0,98}Nb_{0,02}\}O_3$ lässt sich in einen solchen Zusammenhang einordnen.

Sogenannte harte Piezokeramiken mit steilerem Verlauf der ferroelektrischen Hysteresekurve im Polarisations-Feldstärke-Diagramm sind durch den Einbau von Kationen mit niedrigerer Wertigkeit auf den A-Plätzen, also von $A^I$ anstelle von $Pb^{II}$, oder den Einbau niedrigerwertiger Kationen auf den B-Plätzen der Perowskitstruktur herstellbar, im letzteren Fall also $B^{III}$-Kationen wie $Al^{III}$, $Fe^{III}$, $Cr^{III}$ oder $Ga^{III}$ bzw. $B^{II}$-Kationen wie $Mg^{II}$, $Ca^{II}$, $Ni^{II}$, $Co^{II}$ oder $Mn^{II}$ anstelle von $Zr^{IV}/Ti^{IV}$. Mit einer solchen Dotierung geht bei hoher Temperatur die Ausbildung von Leerstellen im Sauerstoffteilgitter einher, wodurch insbesondere die Sinterverdichtung im thermischen Keramisierungsprozess eine signifikante Förderung erfährt. Im Abkühlungsprozess sollten die Leerstellen aber sehr weitgehend durch Sauerstoff aufgefüllt werden, da anderenfalls der Isolationswiderstand und die Alterungsstabilität negativ beeinflusst werden. Harte Piezokeramiken, wie zum Beispiel $Pb_{1-x}K_x(Zr_{0,65}Ti_{0,35})O_{3-x/2}V_{O,x/2}$ ($V_O$ steht hier für eine Sauerstoff-Leerstelle) haben in der Regel einen größeren Elastizitätskoeffizient, kleinere Dielektrizitätskonstante $\varepsilon$ und geringere dielektrische Verluste.

Als besonders vorteilhaft für die Einstellung optimaler piezoelektrischer und piezo-mechanischer Funktionseigenschaften hat sich die Anwendung aliovalenter Substitutionen ohne Valenzkompensation durch sogenannte "weiche" Zusatzstoffe erwiesen, deren Wirkung durch Beimengung "harter" Komponenten partiell kompensiert ist.

Derartige Kombinationen schließen die gemischte Besetzung der B-Plätze durch verschiedene Kationen in der Weise ein, daß sich wiederum Valenzkompensation mit Vollbesetzung sämtlicher Gitterplätze im Perowskitgitter einstellt. Es resultiert daraus eine enorme Erweiterung stofflicher Abwandlungen für PZT-Keramiken.

Vorzugsweise wird bei der Herstellung des hier angegebenen Materials so vorgegangen, daß kristallchemisch geeignet angepasste Verbindungen, die in der vom Kryolith $Na_2(Na,Al)F_6$ abgeleiteten Struktur kristallisieren, Mischkristalle mit dem Perowskitgitter von PZT und ggf. auch mit Mischkristallsystemen ohne und mit Valenzkompensation ausbilden.

Eine besonders gut geeignete Verbindung mit Kryolith-Struktur stellt $Sr_6Nb_2O_{11}$ dar. Die der Struktur angepasste Formulierung $Sr_4(Sr_2Nb_2)O_{11}$ lässt den Zusammenhang zur Perowskitstruktur erkennen. 4 $Sr^{II}$-Kationen besetzen wie in der Perowskitstruktur die A-Plätze mit der Koordinationszahl 12, weitere 2 $Sr^{II}$ sowie 2 $Nb^V$-Kationen alternierend die B-Plätze mit der Koordinationszahl 6, die überall dort auf 5 vermindert ist, wo ein Oxidion fehlt, denn 1/12 der Sauerstoffplätze ist unbesetzt. Bei fester Lösung dieser Verbindung im Perowskitgitter von PZT resultiert daraus eine Förderung des Kornwachstums und der Schwindung im Sinterprozess.

Es wurde gefunden, daß $Sr_6Nb_2O_{11}$ eine Phasenbreite aufweist, die sich bei hoher Temperatur recht weit in Richtung eines höheren Gehalts an $Nb_2O_5$ ausdehnt und daher durch die allgemeine Formel $Sr_{6-2x/3}Nb_{2+2x/3}O_{11+x}V_{1-x}$ bzw., an die Kryolith-Struktur angepasst, durch $Sr_4(Sr_{2-2x/3}Nb_{2+2x/3})O_{11+x}V_{1-x}$ mit 0 < x < 1 beschrieben werden kann. Durch Anwendung eines über die Zusammensetzung $Sr_6Nb_2O_{11}$ hinaus gehenden $Nb_2O_5$ - Gehalts lässt sich daher die Leerstellenkonzentration einstellen und auf diese Weise ein für piezokeramische Anwendungen sehr vorteilhafter Werkstoff herstellen, beispielsweise im System $[Pb(Zr_aTi_{1-a})O_3]_{1-b-c}[KNbO_3]_b(Sr_4(Sr_{2-2x/3}Nb_{2+2x/3})O_{11+x}V_{1-x}]_c$ in den Grenzen 0, 5 < a < 0,6; 0 < b < 0, 5; 0 < c < 0, 05; 0 < x < 1, wobei V eine Leerstelle im Sauerstoff-Teilgitter bedeutet.

Die Phasenbreite der Kryolithkomponente schließt die Möglichkeit einer temperaturabhängigen Variabilität der Sauerstoffleerstellenkonzentration ein, indem zum Beispiel ausgehend von der Zusammensetzung $Sr_4(Sr_{1,667}Nb_{2,333})O_{11,5}V_{0,5}$ mit x = 0,5 bei der Sintertemperatur von 950 bis 1200°C gemäß

$$Sr_4(Sr_{1,667}Nb_{2,333})O_{11,5}V_{0,5} \Rightarrow 0,944\ Sr_4(Sr_2Nb_2)O_{11}V_1 + 0,222\ Nb_2O_5$$

die feste Lösung von $Sr_4(Sr_2Nb_2)O_{11}V_1$ mit erhöhter Sauerstoffleerstellenkonzentration wirksam und das freigesetzte $Nb_2O_5$ durch den als Sinterhilfsmittel eingesetzten PbO-Gehalt als $PbNb_2O_6$ gebunden und unter zusätzlicher Bildung von Leerstellen auf den A-Plätzen in das PZT-Perowskitgitter eingebaut wird. Hervorgerufen durch die Sauerstoffleerstellenbildung enthält das System demnach einen Mechanismus, der die Sinterverdichtung unter gleichmäßigem Kornwachstum fördert. Beim Abkühlen und Tempern ist dagegen gemäß

$$Sr_4(Sr_{1,667}Nb_{2,333})O_{11,5}V_{0,5} \Rightarrow 0,875$$

$$Sr_4(Sr_{1,333}Nb_{2,667})O_{12} + SrO$$

der umgekehrte Vorgang in Betracht zu ziehen. Dieser führt zu einer für die Langzeitstabilität der spannungsbelasteten Piezokeramikbauelemente vorteilhaften Herabminderung bzw. Eliminierung der Sauerstoffleerstellenkonzentration, wobei das ausgeschiedene SrO als die stärkere Base PbO aus $Pb(Zr_aTi_{1-a})O_3$ (PZT) verdrängt, das heißt, es wird etwas PbO freigesetzt und zugleich bildet sich etwas $Sr(Zr_aTi_{1-a})O_3$ (SZT), das mit dem PZT-Wirtsgitter wiederum eine feste Lösung eingeht.

Demnach kann $Sr_4(Sr_2Nb_2)O_{11}V_1$ auch als 0,75 $Sr_4(Sr_{1,333}Nb_{2,667})O_{12}$ ohne Sauerstoff-Leerstellenbildung bzw. in allen Zwischenstufen in das PZT-Wirtsgitter eingebaut werden, wobei sich $\leq 2$ $Sr(Zr_aTi_{1-a})O_3$ (SZT) bilden und im Wirtsgitter lösen. Ebenso kann selbst $Sr_4(Sr_{1,333}Nb_{2,667})O_{12}$ als Quelle von Sauerstoffleerstellen fungieren, indem es sich zu 0,889 $Sr_4(Sr_2Nb_2)O_{11}V_1$ bzw. in einer der Zwischenstufen einbaut, wobei sich $\leq 0,444$ $PbNb_2O_6$ bilden, dessen feste Lösung im PZT-Perowskitgitter mit der Bildung von Leerstellen auf A-Plätzen verbunden ist.

Anstelle von $Sr_4(Sr_{2-2x/3}Nb_{2+2x/3})O_{11+x}V_{1-x}$ lassen sich auch Komponenten mit Kryolith-Struktur verwenden, die anstelle der $Sr^{II}$-Kationen auf den A-Plätzen $Ba^{II}$-Ionen und anstelle der $Sr^{II}$-Kationen auf den B-Plätzen $Ca^{II}$-Ionen oder $Mg^{II}$-Ionen enthalten. Es resultieren daraus die folgenden Formulierungen für Zusatzkomponenten: $Ba_4(Sr_{2-2x/3}Nb_{2+2x/3})O_{11+x}V_{1-x}$ oder $Sr_4(Ca_{2-2x/3}Nb_{2+2x/3})O_{11+x}V_{1-x}$ bzw. $Sr_4(Mg_{2-2x/3}Nb_{2+2x/3})O_{11+x}V_{1-x}$ oder $Ba_4(Ca_{2-2x/3}Nb_{2+2x/3})O_{11+x}V_{1-x}$ bzw. $Ba_4(Mg_{2-2x/3}Nb_{2+2x/3})O_{11+x}V_{1-x}$.

Dadurch wird die Variationsbreite möglicher Abwandlungen von PZT-Keramik noch einmal wesentlich erweitert.

Eine weitere Mannigfaltigkeit ist dadurch gegeben, daß neben diesen Modifizierungen durch Verbindungen mit Kryolith-Struktur als weitere Zusatzkomponente nicht nur $KNbO_3$ in Betracht zu ziehen ist, sondern ebenso eine der bereits aufgeführten Perowskitkomponenten $Pb(M^{II}_{1/3}M^V_{2/3})O_3$ ($M^{II}$: Mg, Zn, Co, Ni, Mn, Cu und $M^V$: Nb, Ta, Sb) oder $Pb(M^{II}_{1/2}M^V_{1/2})O_3$ ($M^{II}$: Mg, Zn, Co, Ni, Mn, Cu und $M^{VI}$: W) oder $Pb(M^{III}_{1/2}M^V_{1/2})O_3$ ($M^{III}$: Fe, Mn, Cr, Ga und $M^V$: Nb, Ta, Sb) bzw. $Pb(M^{III}_{2/3}M^{VI}_{1/3})O_3$ ($M^{III}$: Fe, Mn, Cr, Ga und $M^{VI}$: W) und gegebenenfalls auch $Pb(M^I_{1/4}M^V_{3/4})O_3$ ($M^I$: Li, mit $M^V$: Nb, Ta, Sb) und deren Mischungen zur Anwendung gelangen können.

Diese sind als Zusätze mit fester Lösung im PZT-Perowskitgitter realisierbar. Da es sich stets um eine Aufnahme dieser mit der Perowskitstruktur kompatiblen Zusätze durch das PZT-Wirtsgitter handelt, sind Mischungen der aufgeführten fünf Versionen gleichfalls in Betracht zu ziehen.

Der große Variationsbereich der bisher beschriebenen Lösungen wird bei gemischter B-Platz-Besetzung durch Rezepturen ohne Valenzkompensation komplettiert, die einer Dotierung durch sogenannte "weiche" Zusatzstoffe mit partieller Kompensation durch Beimengung "harter" Komponenten entsprechen, woraus Leerstellen im Perowskitgitter resultieren, die sich besonders vorteilhaft sowohl auf die Gefügeausbildung im Sinterprozess als auf die piezoelektrischen und piezomechanischen Funktionseigenschaften auswirken.

Die hier beschriebene Variabilität der Eigenschaften einer PZT-Keramik, wie sie durch den Einbau einer Kryolithphase mit Phasenbreite hervorgerufen wird, ist dadurch ausgezeichnet, dass sich die vorteilhafte Kombination sogenannter weicher mit harten Komponenten durch das Verhältnis von Niob zu Strontium bzw. einer der anderen Erdalkalien und auch durch die Temperaturführung beeinflussen und dadurch gezielt einstellen lässt.

Die Erfindung wird an folgenden Ausführungsbeispielen und der dazugehörigen Figur näher erläutert.

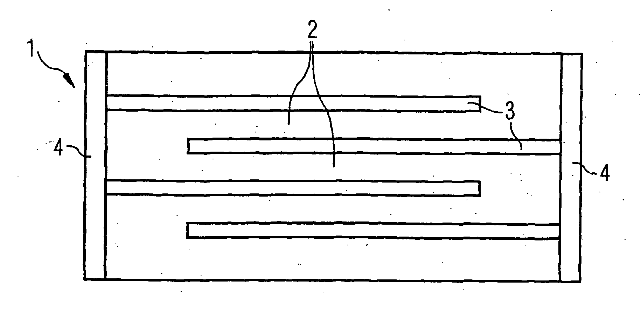

Die Figur zeigt einen Piezoaktor in einem schematischen Längsschnitt.

Die Figur zeigt einen Ausschnitt aus einem Piezoaktor 1, der unter Beteiligung des hier beschriebenen Keramikmaterials gefertigt worden ist. Es sind gezeigt ein Stapel von übereinanderliegenden piezoelektrischen Keramikschichten 2, mit dazwischenliegenden Elektrodenschichten 3. Der Piezoaktor 1 weist ferner seitlich am Keramikkörper Außenelektroden 4 auf. Die Herstellung des in der Figur gezeigten Piezoaktors 1 erfolgt durch Bilden keramischer Grünfolien, welche aus einem der hier beschriebenen Keramikmaterialien gefertigt werden. Eine Vielzahl dieser Grünfolien, beispielsweise 10 oder sogar 100 werden übereinandergestapelt. Zwischen den keramischen Grünfolien werden Elektrodenschichten 3 angeordnet. Die Elektrodenschichten 3 können beispielsweise aus Silber und Palladium bestehen. Die Elektrodenschichten 3 können aber genauso gut auch aus Kupfer bestehen. Die Elektrodenschichten 3 können beispielsweise durch Siebdruck auf die einzelnen keramischen Grünfolien aufgebracht werden. Die übereinandergestapelten keramischen Grünfolien werden miteinander verpresst und anschließend gemeinsam entbindert und gesintert. Daraus resultiert ein monolithischer Keramikkörper mit übereinandergestapelten, piezoelektrischen keramischen Schichten 2. Die inneren Elektrodenschichten 3 weisen kammartig ineinandergreifende Strukturen auf, wobei jede zweite der Elektrodenschichten 3 mit ein und derselben Außenelektrode 4 kontaktiert ist.

Zwischen den Außenelektroden 4 wird die zur elektrischen Charakterisierung des Piezoaktors 1 notwendige elektrische Spannung angelegt.

Zur Herstellung eines hier beschriebenen Keramikmaterials wird eine aus $Pb_3O_4$ oder $PbCO_3$, $TiO_2$, $ZrO_2$ bzw. einem durch Mischfällung hergestellten Precursor $(Zr,Ti)O_2$ sowie $SrCO_3$ und $Nb_2O_5$ und gegebenenfalls weiteren Zusätzen wie zum Beispiel $KNbO_3$ oder $Pb(Fe_{0,5}Nb_{0,5})O_3$ bestehende Rohstoffmischung entsprechend einer der in den Tabellen 1 bis 16 beispielhaft aufgeführten Zusammensetzungen in Molprozent gemischt, oder es gelangt auch eine Mischung mit dem jeweiligen Anteil an vorgefertigter Kryolithphase zur Anwendung.

Tabelle 1 bis 6: Ansätze einer durch Zusätze von Verbindungen mit Kryolithstruktur modifizierten PZT-Keramik $[Pb(Zr_aTi_{1-a})O_3]_{1-b-c}[KNbO_3]_b$.

Tabelle 1

| $[Pb(Zr_aTi_{1-a})O_3]_{1-b-c}[KNbO_3]_b[Sr_4(Sr_{2-2x/3}Nb_{2+2x/3})O_{11+x}V_{1-x}]_c * 0,01\ PbO$ | | | |
|---|---|---|---|
| a = 0,53 | b = 0 | c = 0,0049 | x = 0,5 |
| a = 0, 53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0, 53 | b = 0,007 | c = 0,0035 | x = 0,5 |

Tabelle 2

| $[Pb(Zr_aTi_{1-a})O_3]_{1-b-c}[KNbO_3]_b[Sr_4(Ca_{2-2x/3}Nb_{2+2x/3})O_{11+x}V_{1-x}]_c * 0,01\ PbO$ | | | |
|---|---|---|---|
| a = 0,53 | b = 0 | c = 0,0049 | x = 0,5 |
| a = 0,53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0,53 | b = 0,007 | c = 0,0035 | x = 0,5 |

Tabelle 3

| $[Pb(Zr_aTi_{1-a})O_3]_{1-b-c}[KNbO_3]_b[Sr_4(Mg_{2-2x/3}Nb_{2+2x/3})O_{11+}xV_{1-x}]_c * 0,01\ PbO$ | | | |
|---|---|---|---|
| a = 0,53 | b = 0 | c = 0,0049 | x = 0,5 |
| a = 0,53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0,53 | b = 0,007 | c = 0,0035 | x = 0,5 |

Tabelle 4

| $[Pb(Zr_aTi_{1-a})O_3]_{1-b-c}[KNbO_3]_b[Ba_4(Sr_{2-2x/3}Nb_{2+2x/3})O_{11+x}V_{1-x}]_c * 0, 01\ PbO$ | | | |
|---|---|---|---|
| a = 0,53 | b = 0 | c = 0,0049 | x = 0,5 |

(fortgesetzt)

| $[Pb(Zr_aTi_{1-a})O_3]_{1-b-c}[KNbO_3]_b[Ba_4(Sr_{2-2x/3}Nb_{2+2x/3})O_{11+x}V_{1-x}]_c * 0,01\ PbO$ | | | |
|---|---|---|---|
| a = 0,53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0,53 | b = 0,007 | c = 0,0035 | x = 0,5 |

Tabelle 5

| $[Pb(Zr_aTi_{1-a})O_3]_{1-b-c}[KNbO_3]_b[Ba_4(Ca_{2-2x/3}Nb_{2+2x/3})O_{11+x}V_{1-x}]_c * \cdot 0,01\ PbO$ | | | |
|---|---|---|---|
| a = 0,53 | b = 0 | c = 0,0049 | x = 0,5 |
| a = 0,53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0,53 | b = 0,007 | c = 0,0035 | x = 0,5 |

Tabelle 6

| $[Pb(Zr_aTi_{1-a})O_3]_{1-b-c}[KNbO_3]_b[Ba_4(Mg_{2-2x/3}Nb_{2+2x/3})O_{11+x}V_{1-x}]_c * 0,01\ PbO$ | | | |
|---|---|---|---|
| a = 0,53 | b = 0 | c = 0,0049 | x = 0,5 |
| a = 0,53 | b = 0 | c = 0,0082 | x = 0,5 |
| a = 0,535 | b = 0 | c = 0,0044 | x = 1,0 |
| a = 0,535 | b = 0 | c = 0,0076 | x = 1,0 |
| a = 0,53 | b = 0,002 | c = 0,0047 | x = 1,0 |
| a = 0,53 | b = 0,007 | c = 0,0035 | x = 0,5 |

Tabelle 7 bis 12:

Ansätze einer durch Zusätze von Verbindungen mit Kryolithstruktur modifizierten PZT-Keramik $[Pb(Zr_aTi_{1-a})O_3]_{1-b-c}[Pb(Fe^{III}_{1/2}Nb^V_{1/2})O_3]_b$

Tabelle 7

| $(Pb(Zr_aTi_{1-a})O_3]_{1-b-c}[Pb(Fe^{III}_{1/2}Nb^V_{1/2})O_3]_b(Sr_4(Sr_{2-2x/3}Nb_{2+2x/3})O_{11+x}V_{1-x}]_c \cdot 0,01\ PbO$ | | | |
|---|---|---|---|
| a = 0,53 | b = 0, 003 | c = 0,0047 | x = 1, 0 |
| a = 0,53 | b = 0,008 | c = 0,0035 | x = 0,5 |

Tabelle 8

| $[Pb(Zr_aTi_{1-a})O_3]_{1-b-c}[Pb(Fe^{III}_{1/2}Nb^v_{1/2})O_3]_b[Sr_4(Ca_{2-2x/3}Nb_{2+2x/3})O_{11+x}V_{1-x}]_c \cdot 0,01\ PbO$ | | | |
|---|---|---|---|
| a = 0,53 | b = 0,002 | c = 0,0047 | x = 1, 0 |
| a = 0, 53 | b = 0,007 | c = 0,0035 | x = 0,5 |

Tabelle 9

| $[Pb(Zr_aTi_{1-a})O_3]_{1-b-c}[Pb(Fe^{III}_{1/2}Nb^V_{1/2})O_3]_b[Sr_4(Mg_{2-2x/3}Nb_{2+2x/3})O_{11+x}V_{1-x}]_c * 0,01\ PbO$ | | | |
|---|---|---|---|
| a = 0,53 | b = 0,002 | c = 0,0047 | x = 1,0 |
| a = 0,53 | b = 0,007 | c = 0,0035 | x = 0,5 |

Tabelle 10

| $[Pb(Zr_aTi_{1-a})O_3]_{1-b-c}[Pb(Fe^{III}_{1/2}Nb^V_{1/2})O_3]_b[Ba_4(Sr_{2-2x/3}Nb_{2+2x/3})O_{11+x}V_{1-x}]_c * 0,01\ PbO$ | | | |
|---|---|---|---|
| a = 0,53 | b = 0,002 | c = 0,0047 | x = 1,0 |
| a = 0,53 | b = 0,007 | c = 0,0035 | x = 0,5 |

Tabelle 11

| $[Pb(Zr_aTi_{1-a})O_3]_{1-b-c}[Pb(Fe^{III}_{1/2}Nb^V_{1/2})O_3]_b[Ba_4(Ca_{2-2x/3}Nb_{2+2x/3})O_{11+x}V_{1-x}]_c * 0,01\ PbO$ | | | |
|---|---|---|---|
| a = 0,53 | b = 0,002 | c = 0,0047 | x = 1,0 |
| a = 0,53 | b = 0,007 | c = 0,0035 | x = 0,5 |

Tabelle 12

| $[Pb(Zr_aTi_{1-a})O_3]_{1-b-c}[Pb(Fe^{III}_{1/2}Nb^V_{1/2})O_3]_b[Ba_4(Mg_{2-2x/3}Nb_{2+2x/3})O_{11+x}V_{1-x}]_c * 0,01\ PbO$ | | | |
|---|---|---|---|
| a = 0,53 | b = 0,002 | c = 0,0047 | x = 1,0 |
| a = 0,53 | b = 0,007 | c = 0,0035 | x = 0,5 |

Derartige Rohstoffmischungen werden in bezug auf das Zr zu Ti Verhältnis auf die MPB eingestellt und je nach Zweckmäßigkeit mit einem geringen Überschuss an PbO (ca. 2 %) als Sinterhilfsmittel versehen, zur Gleichverteilung der Komponenten einer Mahlstufe in wässriger Suspension unterzogen und nach dem Filtrieren und Trocknen bei 900 bis 950 °C kalziniert. Dabei bildet sich die piezokeramische Perowskit-Mischkristallphase im wesentlichen bereits aus.

Mittels einer anschließenden Feinmahlung lässt sich die Sinteraktivität an die Sintertemperatur von ca. 1120°C für Ag/Pd-Innenelektroden(75/25) bzw. 1000°C für Cu-Innenelektroden anpassen. Um bereits bei 1000°C unterhalb der Schmelztemperatur von Kupfer Sinterverdichtung zu erreichen, ist eine Feinmahlung bis auf eine mittlere Korngröße < 0,4 $\mu$m erforderlich. Die Sinteraktivität des Pulvers erweist sich dann als ausreichend, um eine Verdichtung von > 96% der theoretischen Dichte bei zugleich hinreichendem Kornwachstum und ausreichender mechanischer Festigkeit im Keramikgefüge zu gewährleisten.

Das fein gemahlene Pulver wird unter Verwendung eines Dispergators zu einem wässrigen Schlicker mit ca. 70 m-% Feststoffgehalt, das entspricht etwa 24 Vol.-%, suspendiert und entweder durch Versprühen in ein pressfähiges Granulat überführt oder zu Keramik-Grünfolien verarbeitet. Dabei wird der für eine optimale Dispergierung gerade notwendige Dispergatoranteil in einer Versuchsreihe gesondert ermittelt, was am Erreichen eines Viskositätsminimums erkannt werden kann. Man fügt zu den dispergierten Feststoffpulversuspensionen 6 - 8 m-% eines Binders zur Einstellung der für den Folienziehprozess erforderlichen Verarbeitungseigenschaften hinzu: Binder auf Polyacrylat Basis oder PVA-Basis, z. B. Polyvinylbutyral PVB, für Piezo-Vielschichtbauelemente, z. B. Aktoren, mit Ag/Pd-Innenelektroden, oder man verwendet die thermohydrolytisch günstiger abbaubaren Polyurethane im Fall eines Aufbaus mit Cu-Innenelektroden. Nach dem Homogenisieren der in dieser Weise auf eine optimale Viskosität und Oberflächenspannung eingestellten Suspension in einer Dispermat-Mühle erhält man einen für den Folienziehprozess geeigneten Schlicker.

Scheibenförmige Preßlinge, hergestellt aus dem Granulat, oder quadratische Mehrlagenplättchen "MLP", gewonnen durch Übereinanderstapeln und Laminieren aus den 40 bis 50 $\mu$m dicken Grünfolien, lassen sich standardmäßig entbindern, ebenso Piezo-Vielschichtbauelemente, z. B. Piezoaktoren, mit bis zu 360 Ag/Pd-Innenelektroden. Im Fall von Cu-Innenelektroden ist sowohl bei der Entbinderung wie bei der Sinterung die Einhaltung eines Sauerstoffpartialdruckes unterhalb der Oxidation von Kupfer geboten, was durch Einstellung einer kontrollierten $H_2O/H_2$-Atmosphär gelingt, deren Zusammensetzung der O-fenkurve in den beiden thermischen Prozessen folgt.

Derartig entbinderte PZT-Keramikproben gestatten die Sinterverdichtung zu einer Keramik mit einer für die piezoelektrischen und piezomechanischen Eigenschaften vorteilhaften Gefügestruktur. Nach dem Kontaktieren durch Sputtern von Au-Elektroden werden die dielektrischen und speziell die piezoelektrischen Eigenschaften an den erhaltenen scheibenförmigen Proben mit den Abmessungen von ca. 10 x 10 mm$^2$ und 0,7 bzw. 2 mm Dicke gemessen. Bei den Vielschichtbauelementen, z.B. Proben von Aktoren, erfolgt das Kontaktieren durch Aufbringen und Einbrennen einer bondfähigen Ag- bzw. Cu-Terminierung.

Der polare Zustand der ferroelektrischen Keramik mit einer Curietemperatur von je nach Zusammensetzung 250 bis 380°C wird durch Polung mit ca. 2 kV/mm eingestellt. Einige der an derartigen Proben erhaltenen piezoelektrische Eigenschaften sind in Tabelle 9 für die durch Kryolith abgewandelten Piezokeramiken beispielhaft zusammengestellt. Zum Vergleich sind Werte einer durch Nd dotierten weichen Keramik in Tabelle 10 mit angegeben. Neben der Dielektrizitätskonstante $\varepsilon$ wurde entsprechend der für den piezoelektrischen Effekt geltenden Beziehung $S_3 = d_{33} \times E_3$ die Dehnung S unter der Wirkung der elektrischen Feldstärke E zwecks Ermittlung der Ladungskonstante d gemessen (der Index 3 bezeichnet die Richtung der durch Polung eingestellten polaren Achse und der angelegten Feldstärke). Weiterhin sind die spezifische Energie und der Verlustfaktor angegeben.

Tabelle 13: Einige im Klein- und im Großsignal-Messregime ermittelte Eigenschaften für scheibenförmige Proben MLP (11 x 11 mm$^2$) und Aktoren mit Ag/Pd-Innenelektroden (n = 350, dielektrische Dicke d = 80 $\mu$m, 6,8 x 6,8 mm$^2$) auf der Basis der Keramik $[Pb(Zr_aTi_{1-a})O_3]_{1-b-c}[KNbO_3]_b[Sr_4(Sr_{2-2x/3}Nb_{2+2x/3})O_{11+x}V_{O;1-x}]_c$ * 0,01 PbO

| | DK $\in$ | $d_{33}$ m/V | $\dfrac{\varepsilon \cdot \varepsilon_0}{d_{33}^2}$  J/m$^3$ | Verlustfaktor bzw. Verlust % |
|---|---|---|---|---|
| $[Pb(Zr_{0,53}Ti_{0,47})O_3] \cdot [Sr_{5,667}Nb_{2,333}O_{11,5}V_{0,5}]_{0,0049}$ + 0,01 PbO | | | | |
| 2 V/mm | 1662 | --- | --- | 0,0177 |
| 2 kV/mm | 2708 | 731·10$^{-12}$ | 4,49·10$^{-10}$ | 44,1 % |
| $[Pb(Zr_{0,535}Ti_{0,465})O_3] \cdot [Sr_{5,333}Nb_{2,667}O_{12}]_{0,0044}$ + 0,01 PbO | | | | |
| 2 V/mm | 1742 | | | |
| 2 kV/mm | 2881 | 722·10$^{-12}$ | 4,89·10$^{-10}$ | 46,9 % |
| $[Pb(Zr_{0,53}Ti_{0,47})O_3] \cdot [KNbO_3]$ 0,002$[Sr_{5,333}Nb_{2667}O_{12}]_{0,0047}$ + 0,01 PbO | | | | |
| 2 V/mm | 1716 | -- | -- | 0,0178 |
| 2 kV/mm | 2837 | 746·10$^{-12}$ | 4,51·10$^{-10}$ | 45,8 % |
| $[Pb(Zr_{0,53}Ti_{0,47})O_3] \cdot [KNbO_3]$ 0,007 $[Sr_{5,667}Nb_{2,333}O_{11,5}V_{0,5}]_{0,0035}$ + 0,01 PbO | | | | |
| 2 V/mm | 1675 | --- | --- | 0,0162 |
| 2 kV/mm | 2827 | 688·10$^{-12}$ | 5,29·10$^{-10}$ | 47, 0 % |

Tabelle 14: Einige im Klein- und im Großsignal-Meßregime ermittelte Eigenschaften für scheibenförmige Proben MLP (11 x 11 x 0,7 mm$^3$) und Aktoren mit Ag/Pd-Innenelektroden (n = 350, dielektrische Dicke d = 80 $\mu$m, 6,8 x 6,8 mm$^2$) auf der Basis der Keramik $Pb_{0,97}Nd_{0,02}V_{0,01}(Zr_{0,54}Ti_{0,46})O_3$ für Proben MLP und auf der Basis von $Pb_{0,96}Nd_{0,02}Ag_{0,02}(Zr_{0,54}Ti_{0,46})O_3$ für Aktoren mit Ag/Pd-Innenelektroden

| | | Dielektrizitätskonstante $\varepsilon$ | $d_{33}$ in m/V | $(E \, \varepsilon_0/d_{33}^2)$ in J/m$^3$ | Verlustfaktor bzw. Verlust $\eta$ |
|---|---|---|---|---|---|
| MLP | E = 2 V/mm | | | | |
| | E= 2 kV/mm | 2428 | 661 10$^{-12}$ | 4,92 . 10$^{10}$ | $\eta$ = 45 % |
| Aktor | E = 2 v/mm | 1708 | | | tan $\delta$ = 0,016 |
| | E = 2 kV/mm | 3534 | 780 10$^{-12}$ | 5,14 . 10$^{10}$ | $\eta$ = 45 % |

Bezugszeichenliste

1    Piezoaktor

2    keramische Schichten

3    Elektrodenschichten

4    Außenelektroden


**Patentansprüche**

1.  Keramikmaterial, bei dem das Keramikmaterial die Summenformel $A'_{1-b-c}B'_b C'_c$ aufweist, wobei gilt: $0 \le b \le 0,5$ und $0 < c \le 0,01$ und wobei

    - A' für die Zusammensetzung $Pb(Zr_a Ti_{1-a})O_3$ steht und wobei gilt $0,5 \le a \le 0,6$, und A' als Wirtsgitter für B' und C' dient,
    - B' für eine Zusatzkomponente vom Perowskit - Gittertyp steht und ausgewählt ist aus einer der folgenden Komponenten:

        -- $KNbO_3$
        -- $Pb(M^{II}_{1/3}M^V_{2/3})O_3$ wobei $M^{II}$ für Co, Ni, Mn oder Cu und wobei $M^V$ für Nb, Ta oder Sb steht,
        -- $Pb(M^{II}_{1/2}M^{VI}_{1/2})O_3$ wobei $M^{II}$ für Zn, Co, Ni, Mn oder Cu und wobei $M^{VI}$ für W steht,
        -- $Pb(M^{III}_{1/2}M^V_{1/2})O_3$ wobei $M^{III}$ für Fe, Mn, Cr oder Ga und wobei $M^V$ für Nb, Ta oder Sb steht,
        -- $Pb(M^{III}_{2/3}M^{VI}_{1/3})O_3$ wobei $M^{III}$ für Fe, Mn, Cr oder Ga und wobei $M^{VI}$ für W steht,
        -- $Pb(Li^I_{1/4}M^V_{3/4})O_3$ wobei $M^V$ für Nb, Ta oder Sb steht,

    - C' für ein Keramikmaterial vom Kryolith - Gittertyp steht, welches die allgemeine Formel $A_4(B_{2-2x/3}Nb_{2+2x/3})O_{11+x}V_{1-x}$ aufweist, und A für Strontium und Barium, B für Strontium, Calcium und Magnesium und V für eine Sauerstoffleerstelle mit Phasenbreite steht, und für den Parameter x gilt: $0 \le x \le 1$, wobei das Keramikmaterial $A'_{1-b-c}B'_b C'_c$ zusätzlich noch einen PbO-Überschuß von bis zu 3 mol-% enthalten kann.

2.  Keramikmaterial nach Anspruch 1,
    bei dem C' die Summenformel $[Sr_4(Sr_{2-2x/3}Nb_{2+2x/3})O_{11+x}V_{1-x}]$ aufweist, wobei V für eine Sauerstoffleerstelle steht und wobei für den Parameter x gilt: $0 \le x \le 1$.

3.  Keramikmaterial nach Anspruch 1,
    bei dem C' die Summenformel $Sr_4(Ca_{2-2x/3}Nb_{2+2x/3})O_{11+x}V_{1-x}$ aufweist, wobei V für eine Sauerstoffleerstelle steht und wobei für den Parameter x gilt: $0 \le x \le 1$.

4.  Keramikmaterial nach Anspruch 1,
    bei dem C' die Summenformel $Sr_4(Mg_{2-2x/3}Nb_2+2x/3)O_{11+x}V_{1-x}$ aufweist, wobei V für eine Sauerstoffleerstelle steht und wobei für den Parameter x gilt: $0 \le x \le 1$.

5.  Keramikmaterial nach Anspruch 1,
    bei dem C' die Summenformel $Ba_4(Sr_{2-2x/3}Nb_{2+2x/3})O_{11+x}V_{1-x}$ aufweist, wobei V für eine Sauerstoffleerstelle steht und wobei für den Parameter x gilt: $0 \le x \le 1$.

6.  Keramikmaterial nach Anspruch 1,
    bei dem C' die Summenformel $Ba_4(Ca_{2-2x/3}Nb_{2+2x/3})O_{11+x}V_{1-x}$ aufweist, wobei V für eine Sauerstoffleerstelle steht und wobei für den Parameter x gilt: $0 \le x \le 1$.

7.  Keramikmaterial nach Anspruch 1,
    bei dem C' die Summenformel $Ba_4(Mg_{2-2x/3}Nb_{2+2x/3})O_{11+x}V_{1-x}$ aufweist, wobei V für eine Sauerstoffleerstelle steht und wobei für den Parameter x gilt: $0 \le x \le 1$.

8. Piezoaktor

   - aufweisend einen monolithischen Stapel von übereinanderliegenden Keramikschichten (2) und dazwischen liegenden Elektrodenschichten (3), wobei wenigstens eine Keramikschicht (2) ein Keramikmaterial nach einem der Ansprüche 1 bis 7 enthält.

9. Verfahren zur Herstellung eines Keramikmaterials nach einem der Ansprüche 1 bis 7,
   wobei Vorläufermaterialien eines Keramikmaterials mit einer Kryolithstruktur mit Vorläufermaterialien einer PZT - Keramik gemischt werden.

10. Verfahren zur Herstellung eines Keramikmaterials nach einem der Ansprüche 1 bis 7,
    wobei eine vorgefertigte Kryolithphase mit Vorläufermaterialien einer PZT - Keramik gemischt wird.

**Claims**

1. Ceramic material, wherein the ceramic material has the empirical formula $A'_{1-b-c}B'_bC'_c$, where: $0 \leq b \leq 0.5$ and $0 < c \leq 0.01$ and

   - A' represents the composition $Pb(Zr_aTi_{1-a})O_3$ and $0.5 \leq a \leq 0.6$ and A' serves as host lattice for B' and C',
   - B' is an additive component of the perovskite lattice type and is selected from the following components:

     -- $KNbO_3$
     -- $Pb(M^{II}_{1/3}M^V_{2/3})O_3$ where $M^{II}$ is Co, Ni, Mn or Cu and where $M^V$ is Nb, Ta or Sb,
     -- $Pb(M^{II}_{1/2}M^{VI}_{1/2})O_3$ where $M^{II}$ is Zn, Co, Ni, Mn or Cu and where $M^{VI}$ is W,
     -- $Pb(M^{III}_{1/2}M^V_{1/2})O_3$ where $M^{III}$ is Fe, Mn, Cr or Ga and $M^V$ is Nb, Ta or Sb,
     -- $Pb(M^{III}_{2/3}M^{VI}_{1/3})O_3$ where $M^{III}$ is Fe, Mn, Cr or Ga and $M^{VI}$ is W,
     -- $Pb(Li^I_{1/4}M^V_{3/4})O_3$ where $M^V$ is Nb, Ta or Sb,

   - C' is a ceramic material of the cryolite lattice type which has the general formula $A_4(B_{2-2x/3}Nb_{2+2x/3})O_{11+x}V_{1-x}$ and A is strontium and barium, B is strontium, calcium and magnesium and V is an oxygen vacancy having a phase range and the parameter x is such that: $0 \leq x \leq 1$, where the ceramic material $A'_{1-b-c}B'_bC'_c$ can additionally contain a PbO excess of up to 3 mol%.

2. Ceramic material according to Claim 1, wherein C' has the empirical formula $[Sr_4(Sr_{2-2x/3}Nb_{2+2x/3})O_{11+x}V_{1-x}]$, where V is an oxygen vacancy and the parameter x is such that: $0 \leq x \leq 1$.

3. Ceramic material according to Claim 1, wherein C' has the empirical formula $Sr_4(Ca_{2-2x/3}Nb_{2+2x/3})O_{11+}V_{1-x}$, where V is an oxygen vacancy and the parameter x is such that: $0 \leq x \leq 1$.

4. Ceramic material according to Claim 1, wherein C' has the empirical formula $Sr_4(Mg_{2-2x/3}Nb_{2+2x/3})O_{11+x}V_{1-x}$, where V is an oxygen vacancy and the parameter x is such that: $0 \leq x \leq 1$.

5. Ceramic material according to Claim 1, wherein C' has the empirical formula $Ba_4(Sr_{2-2x/3}Nb_{2+2x/3})O_{11+x}V_{1-x}$, where V is an oxygen vacancy and the parameter x is such that: $0 \leq x \leq 1$.

6. Ceramic material according to Claim 1, wherein C' has the empirical formula $Ba_4(Ca_{2-2x/3}Nb_{2+2x/3})O_{11+x}V_{1-x}$, where V is an oxygen vacancy and the parameter x is such that: $0 \leq x \leq 1$.

7. Ceramic material according to Claim 1, wherein C' has the empirical formula $Ba_4(Mg_{2-2x/3}Nb_{2+2x/3})O_{11+x}V_{1-x}$, where V is an oxygen vacancy and the parameter x is such that: $0 \leq x \leq 1$.

8. Piezoelectric actuator

   - having a monolithic stack of superposed ceramic layers (2) and electrode layers (3) located in-between, wherein at least one ceramic layer (2) contains a ceramic material according to any of Claims 1 to 7.

9. Process for producing a ceramic material according to any of Claims 1 to 7, wherein precursor materials of a ceramic material having a cryolite structure are mixed with precursor materials of a PZT ceramic.

**10.** Process for producing a ceramic material according to any of Claims 1 to 7, wherein a previously produced cryolite phase is mixed with precursor materials of a PZT ceramic.

## Revendications

**1.** Matériau céramique, le matériau céramique présentant la formule de somme $A'_{1-b-c}B'_bC'_c$ avec $0 \leq b \leq 0, 5$ et $0 < c \leq 0,01$,

- A' représentant le composé $Pb(Zr_aTi_{1-a})O_3$ et $0,5 \leq a \leq 0,6$ et A' servant de réseau-hôte pour B' et C',
- B' représentant un composant supplémentaire de type à réseau de perovskite et étant sélectionné parmi l'un des composants suivants :

$KNbO_3$,
$Pb(M^{II}_{1/3}M^V_{2/3})O_3$, dans laquelle $M^{II}$ représente Co, Ni, Mn ou Cu et $M^V$ représente Nb, Ta ou Sb,
$Pb(M^{II}_{1/2}M^{VI}_{1/2})O_3$ dans laquelle $M^{II}$ représente Zn, Co, Ni, Mn ou Cu et $M^{VI}$ représente W,
$Pb(M^{III}_{1/2}M^V_{1/2})O_3$ dans laquelle $M^{III}$ représente Fe, Mn, Cr ou Ga et $M^V$ représente Nb, Ta ou Sb,
$Pb(M^{III}_{2/3}M^{VI}1_{/3})O_3$ dans laquelle $M^{III}$ représente Fe, Mn, Cr ou Ga et $M^{VI}$ représente W et
$Pb(Li^I_{1/4}M^V_{3/4})O_3$ dans laquelle $M^V$ représente Nb, Ta ou Sb,

- C' représentant un matériau céramique du type à réseau de cryolithe de formule générale $A_4(B_{2-2x/3}Nb_{2+2x/3})O_{11+x}V_{1-x}$, A représentant le strontium et le barium, B le strontium, le calcium et le magnésium et V un emplacement dépourvu d'oxygène avec une largeur de phase, le paramètre x vérifiant la relation $0 \leq x \leq 1$,

le matériau céramique $A'_{1-b-c}B'_bC'c$ pouvant de plus contenir encore un excès de PbO qui peut atteindre 3 % en moles.

**2.** Matériau céramique selon la revendication 1, dans lequel C' représente la formule de somme $[Sr_4(Sr_{2-2x/3}Nb_{2+2x/3})O_{11+x}V_{1-x}]$, dans laquelle V représente un emplacement dépourvu d'oxygène et le paramètre x vérifie la relation : $0 \leq x \leq 1$.

**3.** Matériau céramique selon la revendication 1, dans lequel C' représente la formule de somme $Sr_4(Ca_{2-2x/3}Nb_{2+2x/3})O_{11+x}V_{1-x}$, dans laquelle V représente un emplacement dépourvu d'oxygène et le paramètre x vérifie la relation : $0 \leq x \leq 1$.

**4.** Matériau céramique selon la revendication 1, dans lequel C' représente la formule de somme $Sr_4(Mg_{2-2x}/3Nb_{2+2x/3})O_{11+x}X_{1-x}$, dans laquelle V représente un emplacement dépourvu d'oxygène et le paramètre x vérifie la relation : $0 \leq x \leq 1$.

**5.** Matériau céramique selon la revendication 1, dans lequel C' représente la formule de somme $Ba_4(Sr_{2-2x/3}Nb_{2+2x/3})O_{11+x}V_{1-x}$, dans laquelle V représente un emplacement dépourvu d'oxygène et le paramètre x vérifie la relation : $0 \leq x \leq 1$.

**6.** Matériau céramique selon la revendication 1, dans lequel C' représente la formule de somme $Ba_4(Ca_{2-2x/3}Nb_{2+2x/3})O_{11+x}V_{1-x}$, dans laquelle V représente un emplacement dépourvu d'oxygène et le paramètre x vérifie la relation : $0 \leq x \leq 1$.

**7.** Matériau céramique selon la revendication 1, dans lequel C' représente la formule de somme $Ba_4(Mg_{2-2x/3}Nb_{2+2x/3})O_{11+x}V_{1-x}$, dans laquelle V représente un emplacement dépourvu d'oxygène et le paramètre x vérifie la relation : $0 \leq x \leq 1$.

**8.** Piézoactionneur présentant une pile monolithique de couches céramiques (2) superposées entre lesquelles sont situées des couches d'électrode (3), au moins une couche céramique (2) contenant un matériau céramique selon l'une des revendications 1 à 7.

**9.** Procédé de fabrication d'un matériau céramique selon l'une des revendications 1 à 7, dans lequel des matériaux précurseurs d'un matériau céramique à structure de cryolithe sont mélangés avec des matériaux précurseurs d'une céramique PZT.

10. Procédé de fabrication d'un matériau céramique selon l'une des revendications 1 à 7, dans lequel une phase préfabriquée de cryolithe est mélangée avec des matériaux précurseurs d'une céramique PZT.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9740537 A
- DE 19840488 A1

**In der Beschreibung aufgeführte Nicht-Patentliteratur**

- **C. SCHUH et al.** *Proc. Electroceramics V,* 1996, vol. 1, 201